# EUROPEAN PATENT SPECIFICATION

(11) **EP 1 411 563 B1**
(45) Date of publication and mention of the grant of the patent: **29.12.2010**
(21) Application number: 03020581.9
(22) Date of filing: 18.09.2003
(51) Int. Cl.: H01L 51/05

(54) **Use of poly-3,3"-dialkyl-2,2':5',2"-terthiophenes in a field effect transistor**
Verwendung von poly-3,3"-Dialkyl-2,2':5',2"-terthiophenen in einem Feldeffekttransistor
Utilisation de poly-3,3"-dialkyl-2,2':5',2"-terthiophènes dans un transistor à effet champ

(30) Priority: 15.10.2002 EP 02023109
(43) Date of publication of application: 21.04.2004
(73) Proprietor: Merck Patent GmbH, 64293 Darmstadt (DE); PolyIC GmbH & Co. KG, 90763 Fürth (DE)
(72) Inventor: McCulloch, Iain, Southampton SO53 4LG (GB); Thompson, Marcus, Christchurch BH23 1JR (GB); Giles, Mark, Southampton SO15 2LE (GB); Heeney, Martin, Southampton SO14 6TQ (GB); Tierney, Steven, Southampton SO15 7QW (GB); Rost, Henning, 91056 Erlangen (DE)
(74) Representative: Horstmann, Stefan

(56) References cited:
- US-A- 5 500 537
- L. ANGIOLINI, E. SALATELLI, A. BOLOGNESI, CHIARA BOTTA: "Photoluminescence and electroluminescence of mono- and dialkyl-substituted soluble polythiophenes" E-POLYMERS, [Online] no. 041, 19 September 2002 (2002-09-19), pages 1-7, XP002332572 Retrieved from the Internet: URL:http://www.e-polymers.org/papers/bolog nesi_190902.pdf> [retrieved on 2005-06-15]
- WEI HUANG ET AL: "A NOVEL SERIES OF P-N DIBLOCK LIGHT-EMITTING COPOLYMERS BASED ON OLIGOTHIOPHENES AND 1,4-BIS(OXADIAZOLYL)-2,5-DIALKYLOXYBENZENE " MACROMOLECULES, AMERICAN CHEMICAL SOCIETY. EASTON, US, vol. 32, no. 1, 12 January 1999 (1999-01-12), pages 118-126, XP000790846 ISSN: 0024-9297
- PATENT ABSTRACTS OF JAPAN vol. 1995, no. 04, 31 May 1995 (1995-05-31) & JP 07 011243 A (FUJI ELECTRIC CO LTD), 13 January 1995 (1995-01-13)
- PATENT ABSTRACTS OF JAPAN vol. 2000, no. 07, 29 September 2000 (2000-09-29) & JP 2000 106223 A (FUJI PHOTO FILM CO LTD), 11 April 2000 (2000-04-11)

## Description

The invention relates to the use of poly-3,3"-dialkyl-2,2':5',2"-terthiophenes as charge transport materials or semiconductors in electronic devices, in particular in field effect transistors (FET). The invention further relates to FETS comprising poly-3,3"-dialkyl-2,2':5',2"-terthiophenes.

Organic materials have recently shown promise as the active layer in organic based thin film transistors and organic field effect transistors [see H. E. Katz et al., Acc. Chem. Res., 2001, 34, 5, 359]. Such devices have potential applications in smart cards, security tags and the switching element in flat panel displays. Organic materials are envisaged to have substantial cost advantages over their silicon analogues if they can be deposited from solution, as this enables a fast, large-area fabrication route.

The performance of the device is principally based upon the charge carrier mobility of the semiconducting material and the current on/off ratio, so the ideal semiconductor should have a low conductivity in the off state, combined with a high charge carrier mobility (> 1 x 10⁻³ cm² V⁻¹ s⁻¹). In addition, it is important that the semiconducting material is relatively stable to oxidation, i.e., it has a high ionisation potential, as oxidation leads to reduced device performance.

A known compound which has been shown to be an effective p-type semiconductor for OFETs is pentacene [see S. F. Nelson et al., Appl. Phys. Lett., 1998, 72, 1854]. When deposited as a thin film by vacuum deposition, it was shown to have carrier mobilities in excess of 1 cm² V⁻¹ s⁻¹ with very high current on/off ratios greater than 10⁶. However, vacuum deposition is an expensive processing technique that is unsuitable for the fabrication of large-area films. Regioregular head-to-tail poly(3-hexylthiophene) has been reported with charge carrier mobility between 1 x 10⁻⁵ and 4.5 x 10⁻² cm² V⁻¹ s⁻¹, but with a rather low current on/off ratio between 10 and 10³ [see Z. Bao et al., Appl. Pys. Lett., 1996, 69, 4108]. This low on/off current is due in part to the low ionisation potential of the polymer, which can lead to oxygen doping of the polymer under ambient conditions, and a subsequent high off current [see H. Sirringhaus et al., Adv. Solid State Phys., 1999, 39, 101]. A high regioregularity leads to improved packing and optimised microstructure, leading to improved charge carrier mobility [see H. Sirringhaus et al., Science, 1998, 280, 1741-1744; H. Sirringhaus et al., Nature, 1999, 401, 685-688; and H. Sirringhaus, et al., Synthetic Metals, 2000, 111-112, 129-132]. In general, poly(3-alkylthiophenes) show improved solubility and are able to be solution processed to fabricate large area films. However, poly(3-alkylthiophenes) have relatively low ionisation potentials and are susceptible to doping in air.

It is an aim of the present invention to provide improved materials for use as semiconductors or charge transport materials, which are easy to synthesize, have high charge mobility, good processibility and oxidative stability.

Another aim of the invention is to provide new semiconductor and charge transport components, and new and improved electrooptical, electronic and electroluminescent devices comprising these components, like field effect transistors (FET) as components of integrated circuitry or of thin film transistors (TFT), and organic light emitting diode (OLED) applications like electroluminescent displays or backlights of liquid crystal displays.

Other aims of the invention are immediately evident to those skilled in the art from the following description.

The inventors have found that these aims can be achieved by using poly-3,3"-dialkyl-2,2':5',2"-terthiophenes as semiconductors and charge transport materials.

The synthesis of poly-3,3"-dialkyl-2,2':5',2"-terthiophenes (**1**), wherein R1 and R2 are alkyl groups, via ferric chloride oxidative coupling has been described in WO 94/02530 and M. C. Gallazi, C. Bertarelli, E. Montoneri, Synthetic Metals, 2002, 128, 91.

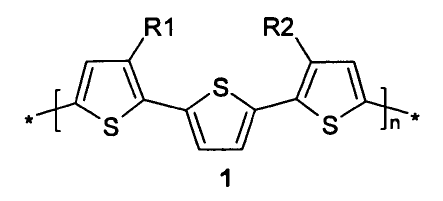

WO 94/02530, EP-A-0 945 723 and WO 99/31494 report the application of poly-3,3"-dialkyl-2,2':5',2"-terthiophenes (**1**) in their doped conductive form as electro-conductive layers in gas sensors. Furthermore, JP-A-63-002251 discloses conductive poly-3,3"-dialkyl-2,2':5',2"-terthiophenes (**1**) prepared via electrolytic polymerisation for use as polymeric cathodes in secondary batteries. However, there have been no reports of the application of poly-3,3"-dialkyl-2,2':5',2"-terthiophenes (**1**) as semiconductors or charge transport materials.

L. Angiolini et al., E-Polymers (online) 041 (2002), 1-7 discloses polyterthiophenes with different substitution patterns and their electroluminescent (EL) and photoluminescent properties, but neither discloses nor suggests that these materials can be used as semiconductor in a FET device.

US 5,500,537 discloses polythiophenes with lateral substituents and their use in FET devices, but does not disclose polyterthiophenes with the specific substitution pattern of the polymers of formula I of the present invention.

The present invention relates to the use of 3,3"-disubstituted poly-2,2':5',2"-terthiophenes of formula I 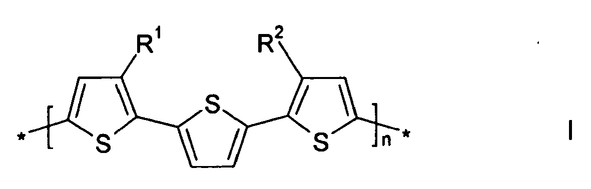 wherein R¹ and R² are independently of each other straight chain or branched alkyl, alkoxy, alkenyl, alkylcarbonyl, alkoxycarbonyl alkylcarbonyloxy, alkylthio, alkylthioalkyl, alkoxyalkyl, alkylsulfinyl or alkylsulfonyl with 1 to 20 C-atoms, or alkylaryl or arylalkyl comprising an alkyl group with 1 to 20 C atoms, and n is an integer > 1, as semiconductor or charge transport material in a FET.

The invention further relates to the use of polymers of formula I as semiconductors or charge transport materials in field effect transistors (FET) for example as components of integrated circuitry, of thin film transistors (TFT) for flat panel display applications, or of radio frequency identification (RFID) tags.

The invention further relates to a semiconducting or charge transport component or device comprising a polymer of formula I as semiconducting or charge transport material.

The invention further relates to a FET, integrated circuit (IC) or TFT comprising a semiconducting or charge transport component or device according to the invention.

The invention further relates to a TFT or TFT array for flat panel displays or radio frequency identification (RFID) tag, comprising a semiconducting or charge transport component or device or a FET, IC or TFT according to the invention.

The invention further relates to a security marking or device comprising a FET or an RFID tag according to the invention.

The semiconductors and charge transport materials and components according to the present invention comprise polymers of formula I, which exhibit both a high degree of planarity in the backbone and strong interchain π-π stacking interactions, making them effective charge transport materials with high carrier mobilities. The alkyl substituents R¹ and R² in formula I are incorporated to solubilise the polymers and make them readily solution processible. Solution processing has the advantage over vacuum deposition processing of being a potentially cheaper and faster technique. Furthermore, the material is perfectly regioregular, which has been shown to improve packing density and optimise microstructure, leading to high carrier mobility. In fact, crystallisation of poly-3,3"-dihexyl-2,2':5',2"-terthiophene was observed by differential scanning calorimetry (DSC) on cooling the polymer melt to 140°C. Therefore, the polymers of formula I are useful as semiconductors or charge transport materials in FETs e.g. as components of integrated circuitry, ID tags or TFT applications.

Especially preferred are polymers of formula I wherein n is an integer from 2 to 5000, in particular from 20 to 1000.

Further preferred are polymers of formula I with a molecular weight from 1000 to 100000.

Further preferred are polymers of formula I wherein R¹ and R² are straight chain alkyl with 1 to 12 C atoms.

The polymers of formula I can be synthesized according to or in analogy to known methods, for example as described in WO 94/02530 and M. C. Gallazi, C. Bertarelli, E. Montoneri, Synthetic Metals, 2002, 128, 91.

The polymers of formula I can also be synthesised *via* other known methods, namely Yamamoto coupling [T. Yamamoto, A. Morita, Y. Miyazaki, T. Maruyama, H. Wakayama, Z. H. Zhou, Y. Nakamura, T. Kanbara, S. Sasaki and K. Kubota, Macromolecules, 1992, 25, 1214.], the McCullough coupling (procedures 1 and 2) [R. D. McCullough et al., J. Chem. Soc., Chem. Commun., 1992. 70; R.S. Loewe et al., Macromolecules, 2000, p. A-J; R. D. McCullough, US Patent 6,166,172], Rieke coupling [T.-A. Chen, R. D. Rieke, J. Am. Chem. Soc., 1992, 114, 10087.], Suzuki coupling [N. Miyaura, T. Yanagi, A. Suzuki, Synth. Commun., 1981, 11, 513.], and Stille coupling [D. Milstein, J. K. Stille, J. Am. Chem. Soc., 1979, 101, 4992.], which is evident to those skilled in the art.

The polymers of formula I show advantageous solubility properties which allow production processes using solutions of these compounds. Thus films, including layers and coatings, may be generated by low cost production techniques, e.g., spin coating. Suitable solvents or solvent mixtures comprise alkanes and/ or aromatics.

The polymers of formula I are useful as semiconductor materials, in particular as charge transport materials in FETs, which can be used, for example, as components of ICs, ID tags or TFT applications.

The polymers of formula I are particularly useful as charge transport materials in FETs. Such FETs, where an organic semiconductive material is arranged as a film between a gate-dielectric and a drain and a source electrode, are generally known, e.g., from US 5,892,244, WO 00/79617, US 5,998,804. Due to the advantages, like low cost production using the solubility properties of the compounds according to the invention and thus the processibility of large surfaces, preferred applications of these FETs are such as ICs, TFT-displays and security applications.

A typical fabrication method of a bottom-gate thin-film transistor (TFT) according to the present invention is described in the following, which should, however, be understood as an exemplary and preferred method, without limiting the scope of the present invention.

A solution of the polymer of formula I in xylene (10 mg/mL) is applied by spin-coating onto a prefabricated transistor substrate. Gold source-drain electrodes are defined by photolithography on a highly doped n+ silicon wafer with a ~210 nm silicon dioxide layer. Before polymer deposition, the hydrophilic silicon dioxide surface is chemically modified e.g. by hexamethyldisilazane (HMDS). Alternatively thin-film transistor (TFT) structures with a top-gate electrode [Sirringhaus et al., Appl. Phys. Lett., 77, p 406-408.] can also be fabricated. For these type of devices, the semiconducting polymer layer typically is spin-coated onto a pre-patterned insulating substrate (glass, plastic etc) with source-drain electrodes. The insulating layer is coated on top, followed by a cross-linking process if necessary. The transistor is finished by depositing a top gate electrode by either some printing technique or a vacuum deposition process.

In security applications, FETs and other devices with semiconductive materials, like transistors or diodes, may be used for ID tags or security markings to authenticate and prevent counterfeiting of documents of value like banknotes, credit cards or ID cards, national ID documents, licenses or any product with money value, like stamps, tickets, shares, cheques etc..

### Example 1

A bottom-gate TFT device was fabricated as described above using poly-3,3"-dihexyl-2,2':5',2"-terthiophene as the semiconducting layer. A charge carrier mobility (µ) of 0.01 cm²/Vs for holes and an on/off ratio (Iₒₙ/I_{off}) of 1 x 10⁶ were measured for the device.

The transistor characteristics are measured with an Agilent 4155C semiconductor parameter analyser under a dry nitrogen atmosphere. I-V curves (output and transfer characteristics) are recorded for a transistor structure with a channel length (L = 10 µm) and a channel width (W = 2 cm).

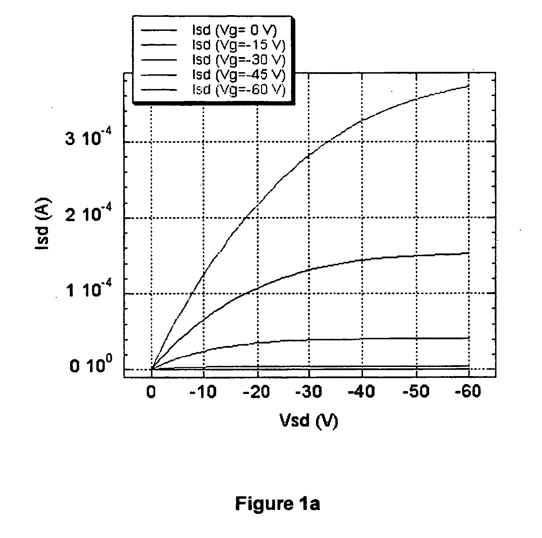

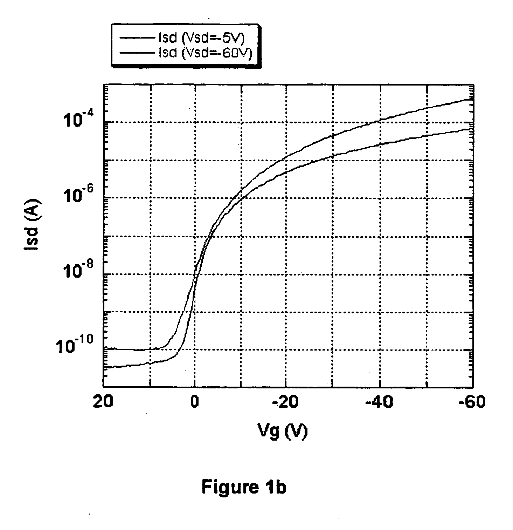

**Figures 1a** **and** **1b** show output (1a) and transfer characteristics (1b), respectively.

In **Figure 1a****,** the Source-Drain voltage (V_{sd}) is varied between 0 and -60 volts with a different bias voltage applied to the gate electrode (V_{g}). The transistor Source-Drain current (I_{sd}) is plotted versus V_{sd} for V_{g} = 0, -15, -30, -45 and -60 V.

In **Figure1b** the transistor Gate voltage (V_{g}) is varied between 20 and -60 volts for two different setting of Source-Drain voltage. The I_{sd} is plotted versus V_{g} for V_{sd}= -5 and -60 V respectively.

## Claims (Claims for the following Contracting State(s): AT, CH, DK, ES, GR, IT, LI, LU, MC, SE)

1. Use of 3,3"-disubstituted poly-2,2':5',2"-terthiophenes of formula I 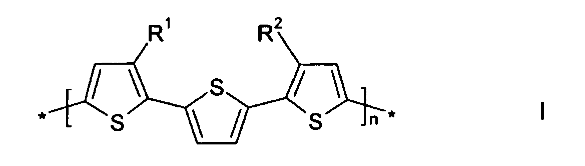 wherein R¹ and R² are independently of each other straight chain or branched alkyl, alkoxy, alkenyl, alkylcarbonyl, alkoxycarbonyl alkylcarbonyloxy, alkylthio, alkylthioalkyl, alkoxyalkyl, alkylsulfinyl or alkylsulfonyl with 1 to 20 C-atoms, or alkylaryl or arylalkyl comprising an alkyl group with 1 to 20 C atoms, and n is an integer > 1, as semiconductor in a field effect transistor (FET).

2. Use according to claim 1, wherein n in formula I is an integer from 2 to 5,000.

3. Use according to claim 1 or 2, wherein R¹ and R² in formula I are straight chain alkyl with 1 to 12 C atoms.

4. FET comprising a polymer as defined in at least one of claims 1 to 3 as semiconductor.

5. FET according to claim 4, wherein the semiconductor is arranged as a film between a gate dielectric and a drain and source electrode.

6. FET according to claim 4 or 5, which is a bottom-gate transistor.

7. Thin film transistor (TFT), TFT array, integrated circuit (IC) or radio frequency identification (RFID) tag, comprising a FET according to one or more of claims 4 to 6.

8. Security marking or device comprising a FET or an RFID tag according to one or more of claims 4 to 7.

## Claims (Claims for the following Contracting State(s): BE, DE, FR, GB, NL)

1. Use of 3,3"-disubstituted poly-2,2':5',2"-terthiophenes of formula I 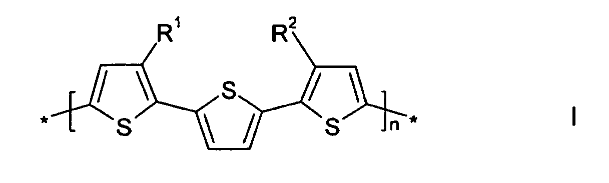 wherein R¹ and R² are independently of each other straight chain or branched alkyl, alkoxy, alkenyl, alkylcarbonyl, alkoxycarbonyl, alkylcarbonyloxy, alkylthio, alkylthioalkyl, alkoxyalkyl, alkylsulfinyl or alkylsulfonyl with 1 to 20 C-atoms, or alkylaryl or arylalkyl comprising an alkyl group with 1 to 20 C atoms, and n is an integer > 1, as semiconductor in a field effect transistor (FET),
wherein the following polymer is excluded from formula I 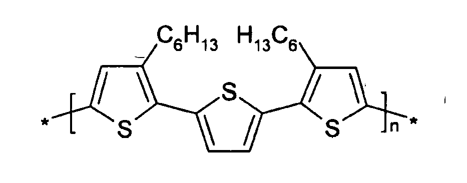 wherein n is from 5 to 5,000.

2. Use according to claim 1, wherein n in formula I is an integer from 2 to 5,000.

3. Use according to claim 1 or 2, wherein R¹ and R² in formula I are straight chain alkyl with 1 to 12 C atoms.

4. FET comprising a polymer as defined in at least one of claims 1 to 3 as semiconductor.

5. FET according to claim 4, wherein the semiconductor is arranged as a film between a gate dielectric and a drain and source electrode.

6. FET according to claim 4 or 5, which is a bottom-gate transistor.

7. Thin film transistor (TFT), TFT array, integrated circuit (IC) or radio frequency identification (RFID) tag, comprising a FET according to one or more of claims 4 to 6.

8. Security marking or device, comprising a FET or an RFID tag according to one or more of claims 4 to 7.

## Patentansprüche (Patentansprüche für folgende(n) Vertragsstaat(en): AT, CH, DK, ES, GR, IT, LI, LU, MC, SE)

1. Verwendung von 3,3"-disubstituierten Poly-2,2':5',2"-terthio-phenen der Formel I 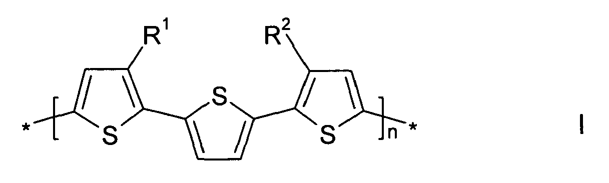 worin R¹ und R² unabhängig voneinander geradkettiges oder verzweigtes Alkyl, Alkoxy, Alkenyl, Alkylcarbonyl, Alkoxycarbonyl, Alkylcarbonyloxy, Alkylthio, Alkylthioalkyl, Alkoxyalkyl, Alkylsulfinyl oder Alkylsulfonyl mit 1 bis 20 C-Atomen oder Alkylaryl oder Arylalkyl enthaltend eine Alkylgruppe mit 1 bis 20 C-Atomen bedeuten und n für eine ganze Zahl > 1 steht, als Halbleiter in einem Feldeffekttransistor (FET).

2. Verwendung nach Anspruch 1, wobei in Formel I n für eine ganze Zahl von 2 bis 5000 steht.

3. Verwendung nach Anspruch 1 oder 2, wobei in Formel R¹ und R² geradkettiges Alkyl mit 1 bis 12 C-Atomen bedeuten.

4. FET enthaltend ein Polymer wie in mindestens einem der Ansprüche 1 bis 3 definiert als Halbleiter.

5. FET nach Anspruch 4, wobei der Halbleiter als Film zwischen einem Gate-Dielektrikum und einer Drain- und Source-Elektrode angeordnet ist.

6. FET nach Anspruch 4 oder 5, bei dem es sich um einen Bottom-Gate-Transistor handelt.

7. Dünnschichttransistor (thin film transistor - TFT), TFT-Anordnung, integrierte Schaltung (integrated circuit - IC) oder RFID-Tag (RFID - radio frequency identification), enthaltend einen FET nach einem oder mehreren der Ansprüche 4 bis 6.

8. Sicherheitsmarkierung oder -vorrichtung, die einen FET oder ein RFID-Tag nach einem oder mehreren der Ansprüche 4 bis 7 enthält.

## Patentansprüche (Patentansprüche für folgende(n) Vertragsstaat(en): BE, DE, FR, GB, NL)

1. Verwendung von 3,3"-disubstituierten Poly-2,2':5',2"-terthio-phenen der Formel I 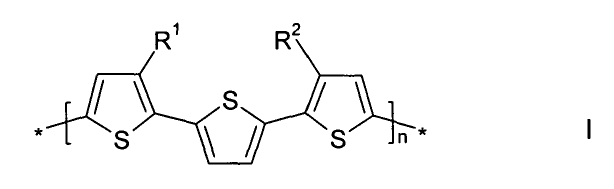 worin R¹ und R² unabhängig voneinander geradkettiges oder verzweigtes Alkyl, Alkoxy, Alkenyl, Alkylcarbonyl, Alkoxycarbonyl, Alkylcarbonyloxy, Alkylthio, Alkylthioalkyl, Alkoxyalkyl, Alkylsulfinyl oder Alkylsulfonyl mit 1 bis 20 C-Atomen oder Alkylaryl oder Arylalkyl enthaltend eine Alkylgruppe mit 1 bis 20 C-Atomen bedeuten und n für eine ganze Zahl > 1 steht, als Halbleiter in einem Feldeffekttransistor (FET),
wobei das folgende Polymer von der Formel I ausgenommen ist: 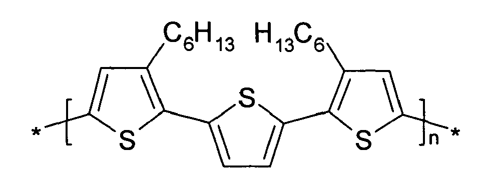 worin n für 5 bis 5000 steht.

2. Verwendung nach Anspruch 1, wobei in Formel I n für eine ganze Zahl von 2 bis 5000 steht.

3. Verwendung nach Anspruch 1 oder 2, wobei in Formel R¹ und R² geradkettiges Alkyl mit 1 bis 12 C-Atomen bedeuten.

4. FET enthaltend ein Polymer wie in mindestens einem der Ansprüche 1 bis 3 definiert als Halbleiter.

5. FET nach Anspruch 4, wobei der Halbleiter als Film zwischen einem Gate-Dielektrikum und einer Drain- und Source-Elektrode angeordnet ist.

6. FET nach Anspruch 4 oder 5, bei dem es sich um einen Bottom-Gate-Transistor handelt.

7. Dünnschichttransistor (thin film transistor - TFT), TFT-Anordnung, integrierte Schaltung (integrated circuit - IC) oder RFID-Tag (RFID - radio frequency identification), enthaltend einen FET nach einem oder mehreren der Ansprüche 4 bis 6.

8. Sicherheitsmarkierung oder -vorrichtung, die einen FET oder ein RFID-Tag nach einem oder mehreren der Ansprüche 4 bis 7 enthält.

## Revendications (Revendications pour l'(les) Etat(s) contractant(s) suivant(s): AT, CH, DK, ES, GR, IT, LI, LU, MC, SE)

1. Utilisation de poly-2,2':5',2"-terthiophènes 3,3"-disubstitués de la formule I 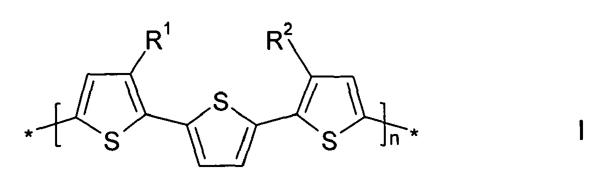 dans laquelle R¹ et R² sont indépendamment l'un de l'autre alkyle, alcoxy, alkényle, alkylcarbonyle, alcoxycarbonyle alkylcarbonyloxy, alkylthio, alkylthioalkyle, alcoxyalkyle, alkylsulfinyle ou alkylsulfonyle en chaîne droit ou ramifié avec 1 à 20 atomes de C, ou alkylaryle ou arylalkyle comprenant un groupe alkyle avec 1 à 20 atomes de C, et n est un entier > 1, en tant que semiconducteur dans un transistor à effet de champ (FET).

2. Utilisation selon la revendication 1, dans laquelle n dans la formule I est un entier de 2 à 5000.

3. Utilisation selon la revendication 1 ou 2, dans laquelle R¹ et R² dans la formule I sont alkyle en chaîne droite avec 1 à 12 atomes de C.

4. FET comprenant un polymère comme défini dans au moins l'une des revendications 1 à 3 en tant que semiconducteur.

5. FET selon la revendication 4, dans lequel le semiconducteur est agencé en tant que film entre un diélectrique de grille et une électrode de drain et de source.

6. FET selon la revendication 4 ou 5, lequel est un transistor à grille de fond.

7. Transistor à film mince (TFT), réseau de TFT, circuit intégré (IC) ou étiquette d'identification radio fréquence (RFID), comprenant un FET selon une ou plusieurs des revendications 4 à 6.

8. Marquage ou dispositif de sécurité comprenant un FET ou une étiquette RFID selon une ou plusieurs des revendications 4 à 7.

## Revendications (Revendications pour l'(les) Etat(s) contractant(s) suivant(s): BE, DE, FR, GB, NL)

1. Utilisation de poly-2,2':5`,2"-terthiophènes 3,3"-disubstitués de la formule I 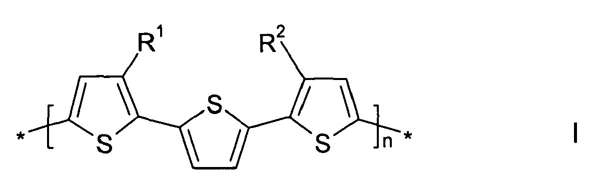 dans laquelle R¹ et R² sont indépendamment l'un de l'autre alkyle, alcoxy, alkényle, alkylcarbonyle, alcoxycarbonyle alkylcarbonyloxy, alkylthio, alkylthioalkyle, alcoxyalkyle, alkylsulfinyle ou alkylsulfonyle en chaîne droit ou ramifié avec 1 à 20 atomes de C, ou alkylaryle ou arylalkyle comprenant un groupe alkyle avec 1 à 20 atomes de C, et n est un entier > 1, en tant que semiconducteur dans un transistor à effet de champ (FET)
dans laquelle le polymère suivant est exclu de la formule I 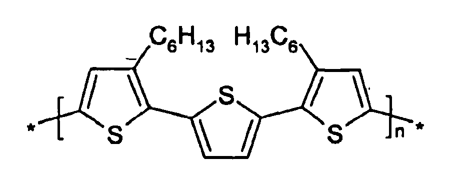 dans laquelle n est de 5 à 5000.

2. Utilisation selon la revendication 1, dans laquelle n dans la formule I est un entier de 2 à 5000.

3. Utilisation selon la revendication 1 ou 2, dans laquelle R¹ et R² dans la formule I sont alkyle en chaîne droite avec 1 à 12 atomes de C.

4. FET comprenant un polymère comme défini dans au moins l'une des revendications 1 à 3 en tant que semiconducteur.

5. FET selon la revendication 4, dans lequel le semiconducteur est agencé en tant que film entre un diélectrique de grille et une électrode de drain et de source.

6. FET selon la revendication 4 ou 5, lequel est un transistor à grille de fond.

7. Transistor à film mince (TFT), réseau de TFT, circuit intégré (IC) ou étiquette d'identification radio fréquence (RFID), comprenant un FET selon une ou plusieurs des revendications 4 à 6.

8. Marquage ou dispositif de sécurité comprenant un FET ou une étiquette RFID selon une ou plusieurs des revendications 4 à 7.
